Europäisches Patentamt

European Patent Office

Office européen des brevets

(11) Veröffentlichungsnummer: **0 224 854 B1**

(12) **EUROPÄISCHE PATENTSCHRIFT**

(45) Veröffentlichungstag der Patentschrift: **13.05.92**

(21) Anmeldenummer: **86116361.6**

(22) Anmeldetag: **25.11.86**

(51) Int. Cl.⁵: **G01R 33/46**

(54) **Verfahren zur Aufnahme von Kernresonanzspektren.**

(30) Priorität: **06.12.85 DE 3543123**

(43) Veröffentlichungstag der Anmeldung:
**10.06.87 Patentblatt 87/24**

(45) Bekanntmachung des Hinweises auf die
Patenterteilung:
**13.05.92 Patentblatt 92/20**

(84) Benannte Vertragsstaaten:
**CH DE FR GB LI**

(56) Entgegenhaltungen:
**EP-A- 0 089 034**
**EP-A- 0 152 879**
**DE-A- 3 512 249**
**GB-A- 2 109 116**
**US-A- 4 134 058**

(73) Patentinhaber: **Spectrospin AG**
**Industriestrasse 26**
**CH-8117 Zürich-Fällanden(CH)**

(72) Erfinder: **Sorensen, Ole W.**
**Lab. für Phys. Chemie ETH-Zentrum**
**CH-8092 Zürich(CH)**

(74) Vertreter: **KOHLER SCHMID + PARTNER Patentanwälte**
**Ruppmannstrasse 27**
**W-7000 Stuttgart 80(DE)**

**Beschreibung**

Die Erfindung betrifft ein Verfahren zur Aufnahme der Kernresonanzspektren von molekularen Spinsystemen, zwischen denen eine Wechselwirkung stattfindet, bei dem die Spinsysteme durch einen 90°-Impuls angeregt werden und die Beobachtung der Resonanzsignale der angeregten Spinsysteme erst nach Ablauf einer auf den 90°-Impuls folgenden Entwicklungszeit $t_1$ stattfindet.

Zwischen den Spins komplizierter Moleküle finden häufig Kopplungen statt, die zu einer Aufspaltung der Linien eines NMR-Spektrums führen. Obwohl eine solche Linienaufspaltung wertvolle Informationen über die vorhandenen Kopplungen und damit über den Molekülaufbau liefert, kann sie andererseits die Analyse eines Spektrums stark erschweren, weil sich die durch eine Linienaufspaltung entstehenden Multiplets überlappen können, so daß die Zuordnung der einzelnen Linien nicht mehr ohne weiteres möglich ist. Bei der 2D-Spektroskopie entstehen durch Wechselwirkungen die sog. Kreuzlinien. Die Interpretation des Spektrums ist in hohem Maße erschwert, wenn sich Gruppen von Kreuzlinien überlappen. Es sind zwar verschiedene Verfahren bekannt, um aus 2D-Spektren durch Kopplung bedingte, störende Linien zu eliminieren (siehe z.B. DE-OS 31 43 625), jedoch war es bisher nicht möglich, die während der Entwicklungszeit $t_1$ eintretenden Wirkungen einer skalaren Spin-Spin-Kopplung allgemein zu eliminieren, d.h. eine homonukleare Entkopplung in Richtung der $\omega_1$-Frequenzachse zu erzielen. Zwar ermöglicht das von Bax und Freeman in J.Magn.Reson. 1981, 44, 542 beschriebene Konstantzeit-Experiment eine Entkopplung, jedoch leidet dieses Verfahren an einer starken Abhängigkeit der Signalintensitäten von den Relaxationszeiten und den J-Kopplungskonstanten.

Der Erfindung liegt demnach die Aufgabe zugrunde, ein Verfahren zur Aufnahme von Kernresonanzspektren anzugeben, das es ermöglicht, die bei Vorliegen einer J-Kopplung infolge der skalaren homonuklearen Spin-Spin-Wechselwirkungen stattfindenden Entwicklungen zu refokussieren und dadurch die Wirkungen der skalaren Spin-Spin-Kopplungen während der Entwicklungszeit in bezug auf die $\omega_1$-Frequenzachse zu eliminieren.

Diese Aufgabe wird nach der Erfindung dadurch gelöst, daß das Spinsystem nach Ablauf der halben Entwicklungszeit $(t_1/2)$ mit einem Zeitumkehr-Impuls bestrahlt wird, der eine Drehung der Spinmomente um einen Flipwinkel $\beta_n$ bewirkt und dessen HF-Schwingung gegenüber einer Referenzphasenlage eine Phasenverschiebung $\phi_q$ aufweist, wogegen die HF-Schwingung des dem Zeitumkehr-Impuls vorausgehenden 90°-Impulses und ggf. weiterer, vor dem Zeitumkehr-Impuls verwendeter HF-Impulse gegenüber der Referenzphasenlage eine Phasenverschiebung um einen Winkel $\psi + \beta_n$ aufweist, in dem $\psi$ entweder o oder $\pi$ bedeutet und $\beta_n$ mit dem Flipwinkel des Zeitumkehr-Impulses übereinstimmt und durch die maximale Anzahl N der im Spinsystem miteinander gekoppelten Spins gemäß der Gleichung

$$\beta_n = n\frac{\pi}{N} \text{ mit } n = 0, 1, 2, \dots N\text{-}1, N\text{+}1, \dots 2N\text{-}1$$

bestimmt ist und wogegen $\phi_q$ unabhängig von $\beta_n$ nacheinander einen der Werte

$$\phi_q = q\frac{2\pi}{3} \text{ mit } q = 0, 1, 2$$

annimmt, und daß die mit dem Gewichtungsfaktor

$$W_n = \frac{1}{2}B_o + \sum_{p=1}^{K} B_p \cos(p\beta_n) - \frac{1}{4}B_K \cos(K\beta_n)\delta_{K,N}$$

multiplizierten Signale, die aufgrund von 3(2N-1) Anregungen erhalten werden, zu einem resultierenden Signal addiert werden, welcher Gewichtsfaktor die Fourier-Transformierte der Faktoren

$$B_p = \frac{(-1)^p}{12}(3p^2 - K^2 - \frac{1}{2})$$

2

ist, in denen K die höchste Anzahl der tatsächlich im Spinsystem vorkommenden Kopplungen angibt und p eine sich zwischen O und K fortlaufend ändernde, ganze Zahl ist, weshalb

$$B_o = \frac{-(2K^2 + 1)}{24} \quad \text{und} \quad B_K = (-1)\frac{K(4K^2-1)}{24} \,,$$

während $\delta_{K,N}$ den Wert 1 hat, wenn N = K, und sonst null ist.

Bei dem erfindungsgemäßen Verfahren werden also statt der sonst üblichen einfachen Induktionssignale durch Aufsummieren einer Anzahl nach dem erfindungsgemäßen Verfahren erzeugter, unterschiedlicher Signale gebildete Signale S verwendet, die sich aus der folgenden Gleichung ergeben

$$S = \sum_{n=0}^{2N-1} \left(W_n \cdot \sum_{q=0}^{2} s_{nq}\right),$$

in der $s_{nq}$ die durch Variation von n und q gewonnenen, einzelnen Induktionssignale sind.

Das erfindungsgemäße Verfahren bewirkt eine zeitliche Umkehr der Entwicklung, die infolge einer skalaren Spin-Spin-Kopplung stattfindet, mit dem Ergebnis einer homonuklearen Entkopplung, die frei von den Nachteilen des Konstantzeit-Experimentes ist. Das Prinzip beruht auf den verschiedenen Abhängigkeiten der verschiedenen Kohärenz-Übertragungswege von dem Drehwinkel $\beta$ einer Zeitumkehrdrehung, die an einem geeigneten Ort eingeführt wird. Der Zeitumkehr-Impuls, der im folgenden auch kurz TR-Impuls (time reversal) oder auch TR-Element genannt wird, bewirkt eine einzigartige Auswahl jener Übertragungswege, welche eine zeitliche Umkehr der durch die J-Kopplung bedingten Entwicklung zur Folge haben.

Die Bedingungen für eine Zeitumkehr können leicht in Form der Spinmultiplet-Komponenten, ausgedrückt als Produkt-Operatoren, angegeben werden. Beispielsweise bezeichnet

$$I_1^+ I_2^\alpha I_3^\beta$$

eine Kohärenz des Spins $I_1$ mit den Kopplungspartnern $I_2$ und $I_3$ in ihren $\alpha$- bzw. $\beta$-Zuständen. Eine zeitliche Umkehr der J-Entwicklung findet statt, wenn durch das angegebene Verfahren alle passiven Spins ($I_2$, $I_3$) umgekehrt werden, während der aktive Spin ($I_1$) unbeeinflußt bleibt, also

$$I_1^+ I_2^\alpha I_3^\beta$$

übergeht in

$$I_1^+ I_2^\beta I_3^\alpha$$

Es gibt keine einzige, nicht selektive Drehung, welche diese Forderung erfüllt. Jedoch hat das erfindungsgemäße Verfahren die gewünschte Wirkung, weil dabei Signale miteinander kombiniert werden, welche durch Verwendung eines TR-Impulses mit variablem Drehwinkel $\beta_n$ erhalten werden, wobei in dem oben angegebenen Fall eine Abhängigkeit von $\beta$ besteht, die durch

$\cos^2(\beta/2)\sin^4(\beta/2)$ gegeben ist.

Insofern steht das Prinzip des erfindungsgemäßen Verfahrens in einer gewissen Beziehung zu der sog. E.Cosy-Technik (ETH-Diss. Nr. 7658, 1984 und J.Am.Chem.Soc. 1985 107, 6394).

Obwohl das erfindungsgemäße Verfahren besondere Bedeutung für homonukleare Spin-Spin-Entkopplung (J-Entkopplung) bei der Aufnahme von 2D-Spektrogrammen hat, hat es auch allgemeine Bedeutung für die zeitliche Umkehr der durch J-Kopplungen bedingten Entwicklungen und damit die Eliminierung von störenden J-bedingten Signaldämpfungen. Das erfindungsgemäße Verfahren ist in vielfältiger Weise bei der Untersuchung von biologischen Makromolekülen mittels der NMR-Spektroskopie anwendbar, wo sonst konventionelle NMR-Spektren Bereiche mit einer starken Überlappung der Resonanzen aufweisen. Die Beseitigung der Multiplet-Aufspaltungen, d.h. eine Refokussierung der J-Entwicklungen, kann eine solche Überlappung beseitigen und daher neu spektrale Bereiche für eine Interpretation zugänglich machen. Verwendungsmöglichkeiten bestehen auch bei heteronuklearen Spinsystemen und allgemein in der 2D-Austausch-Spektroskopie. Gleichfalls kann das Verfahren bei der Mehrquantenspektroskopie und bei indirekter Beobachtung der magnetischen Resonanz Verwendung finden.

Bei einer bevorzugten Ausführungsform des erfindungsgemäßen Verfahrens wird der Zeitumkehr- oder TR-Impuls aus zwei Abschnitten zusammengesetzt, nämlich aus einem ersten Abschnitt in Form eines $90°$-Impulses mit der Phase $\beta_n + \phi_q$ und aus einem dem ersten Abschnitt ggf. mit einem gegenüber der Entwicklungszeit kurzen, zeitlichen Abstand $\tau$ folgenden zweiten Abschnitt in Form eines $90°$-Impulses mit der Phase $\pi + \phi_q$. Dabei ist $\tau$ die Zeit, die benötigt wird, um die HF-Phase zu ändern. Ein typischer Wert für $\tau$ ist $5 . 10^{-6}$ Sekunden. Die Realisierung des TR-Impulses mittels zweier Abschnitte in Form von $90°$-Impulsen mit unterschiedlichen Phasenlagen ist mit herkömmlichen NMR-Spektrometern genauer als die Erzeugung eines Impulses, der aufgrund seines Energieinhaltes einen von $90°$ verschiedenen, vorgegebenen Drehwinkel $\beta_n$ bewirken soll.

Wie bereits erwähnt, ist das erfindungsgemäße Verfahren insbesondere für die Verwendung bei der Aufnahme von 2D-Spektren geeignet. Demgemäß sieht eine bevorzugte Ausführungsform des erfindungsgemäßen Verfahrens die Verwendung von zur Aufnahme von zweidimensionalen Kernresonanzspektren geeigneten Impulsfolgen vor, in die der Zeitumkehr-Impuls eingefügt ist und bei denen die Phase der HF-Schwingung der dem Zeitumkehr-Impuls vorausgehenden Anregungsimpulse um den Winkel $\beta_n$ verschoben ist. So kann beispielsweise für NOESY-Experimente (N̲uclear O̲verhauser E̲nhancement S̲pectroscopY) die Impulsfolge

$$90°(\beta + \psi_1) \text{ -}\tfrac{1}{2}t_1 \text{ - } 90°(\beta + \phi) \text{ -}\tau\text{- } 90°(\pi + \phi) \text{ -}\tfrac{1}{2}t_1 \text{ -}90°(0) \text{ -}\tau_m \text{ - } 90°(\psi_2) \text{ - acq. } (\psi_1 + \psi_2)$$

Anwendung finden, bei der $\psi_1$ und $\psi_2$ in unabhängigem zyklischen Wechsel die Phasenwinkel 0 und $\pi$ bedeuten. Dies ergibt einen minimalen 12(2N-1) Schritt Phasenzyklus.

Wird die Erfindung bei einem Verfahren zur Untersuchung von Spinsystemen von heteronuklearer Kopplung verwendet, bei dem durch eine erste Impulsfolge eine erste Kernart unmittelbar angeregt und dann durch eine zweite Impulsfolge die durch Kopplung erfolgte Anregung der zweiten Kernart abgefragt wird, so wird der Zeitumkehr-Impuls in die erste Impulsfolge eingefügt. Es versteht sich, daß auch hier wieder die entsprechende Phasenverschiebung der dem TR-Impuls vorangehenden Impulse stattfinden muß und die Experimente mit den nach der Erfindung vorgesehenen Änderungen der verschiedenen Winkel wiederholt und die erhaltenen und mit dem angegebenen Gewichtungsfaktor multiplizierten Signale addiert werden müssen, um das von der Kopplung befreite Signal zu erhalten.

Eine indirekte Untersuchung von Spinsystemen mit heteronuklearer Kopplung kann in bekannter Weise dadurch stattfinden, daß mittels einer ersten Impulsfolge eine erste Kernart und mittels einer zweiten Impulsfolge eine zweite Kernart angeregt wird, und zwar derart, daß ein einem ersten $90°$-Impuls der ersten Impulsfolge folgender erster $180°$-Impuls in die Mitte zwischen zwei $90°$-Impulse der zweiten Impulsfolge fällt. Bei einem solchen Verfahren kann die Erfindung dadurch angewendet werden, daß der Zeitumkehr-Impuls in die erste Impulsfolge an einer Stelle eingefügt wird, die zeitlich mit dem zweiten $90°$-Impuls der zweiten Impulsfolge zusammenfällt, daß dem Zeitumkehrimpuls ein weiterer $180°$ Impuls in einem zeitlichen Abstand folgt, der dem Abstand des ersten $180°$-Impulses von dem ersten $90°$-Impuls gleich ist, und daß die Abtastung des von der ersten Kernart gelieferten Resonanzsignals in einem zeitlichen Abstand vom weiteren $180°$-Impuls beginnt, der dem zeitlichen Abstand des Zeitumkehr-Impulses von dem ersten $180°$-Impuls gleich ist, so daß der Zeitumkehr-Impuls in die Mitte zwischen den ersten $90°$-Impuls und den Beginn der Signalabtastung fällt.

Weitere Einzelheiten und Ausgestaltungen der Erfindung ergeben sich aus der folgenden Beschreibung der in der Zeichnung dargestellten Ausführungsbeispiele. Die der Beschreibung und der Zeichnung zu entnehmenden Merkmale können bei anderen Ausführungsformen der Erfindung einzeln für sich oder zu mehreren in beliebiger Kombination Anwendung finden.

Es zeigen

Fig. 1 das Diagramm der für ein 2D-NOESY-Experiment benötigten, nach der Erfindung modifizierten Impulsfolge,

Fig. 2 die Wiedergabe eines 2D-NOE-Spektrums von Decapeptid-LHRH,

Fig. 3 und 4 zwei Bereiche des in Fig. 2 dargestellten Spektrums in vergrößertem Maßstab jeweils ohne und mit Reversierung durch einen Zeitumkehr-Impuls und

Fig. 5 bis 10 weitere Diagramme von nach der Erfindung modifizierten Impulsfolgen.

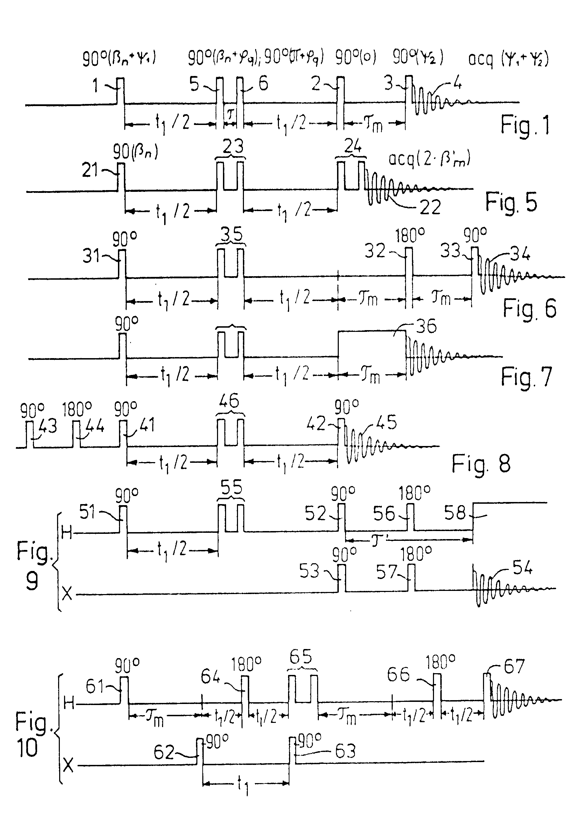

Fig. 1 zeigt das Diagramm einer Impulsfolge, wie sie in der 2D-NOE-Spektroskopie Anwendung findet. Typisch für diese Impulsfolge sind drei 90°-Impulse 1, 2, 3, von denen der erste 90°-Impuls 1 das Spinsystem der zu untersuchenden Probe anregt, der zweite 90°-Impuls nach einer Entwicklungszeit $t_1$ die Anregung wiederholt, um den Einfluß von Spin-Spin-Kopplungen festzustellen, während der dritte 90°-Impuls 3 eine Mischzeit $\tau_m$ beendet, die sich an den zweiten 90°-Impuls 2 anschließt. Im Anschluß an den dritten 90°-Impuls wird das Resonanzsignal als Interferogramm 4 empfangen und aufgezeichnet. Dabei hat gegenüber dem am Ende der Entwicklungszeit $t_1$ erscheinenden 90°-Impuls 2 die HF-Schwingung des ersten und des letzten 90°-Impulses die Phasenlage $\psi_1$ bzw. $\psi_2$, während die phasenempfindliche Gleichrichtung des Interferogrammes 4 mit einem Hochfrequenzsignal der Phase $\psi_1 + \psi_2$ abwechselnd die Werte 0 und $\pi$ annehmen.

Nach der Erfindung wird zwischen die ersten beiden 90°-Impulse, welche die Entwicklungszeit $t_1$ bestimmen, ein Zeitumkehr-Impuls oder TR-Impuls eingeschaltet, der bei dem dargestellten Ausführungsbeispiel aus zwei Anteilen besteht, nämlich zwei 90°-Impulsen 5 und 6, die in einem zeitlichen Abstand $\tau$ aufeinander folgen und jeweils von dem benachbarten 90°-Impuls 1 bzw. 2 den Abstand $t_{1/2}$ haben. Die HF-Schwingung des ersten 90°-Impulses 5 hat den Phasenwinkel $\beta_n + \phi_q$, während die HF-Schwingung des zweiten 90°-Impulses die Phasenlage $\pi + \phi_q$ hat. Die beiden 90°-Impulse 5, 6 haben die Wirkung eines Impulses, der eine Drehung der Spinmomente um den Winkel $\beta_n$ zur Folge hat und dessen Phase um $\phi_q$ verschoben ist. Außerdem ist bei der in Fig. 1 dargestellten Impulsfolge der Phasenwinkel des ersten 90°-Impulses um $\beta_n$ verschoben, so daß die HF-Schwingung dieses Impulses den Phasenwinkel $\beta_n + \psi_1$ hat.

Der Phasenwinkel $\beta_n$ ist bestimmt durch die angenommene maximale Anzahl N - 1 der Kopplungspartner jedes relevanten Spins in der Probe. Der Phasenwinkel $\beta_n$ wird in Schritten $\pi/N$ verändert, so daß für 2N-1 aufeinanderfolgende Anregungen

gilt, $\beta n = \frac{\pi}{N}$ mit n = 0, 1, 2, ..., N-1, N+1, ..., 2N-1.

Dieser Phasenzyklus für $\beta_n$ wird unter Betrachtung der Mehrfach-Quanten-Kohärenzen (MQC) abgeleitet, die von dem 90°-Impuls 5 mit der Phase $\beta_n + \phi_q$ des Zeitumkehr-Impulses erregt werden. Die Mehrfach-Quanten-Kohärenzen müssen in dem Verhältnis

$$B_p = \frac{(-1)^p}{12}\left(3_p^2 - K^2 - \frac{1}{2}\right)$$

kombiniert werden. In dieser Beziehung ist K die Zahl der höchsten tatsächlich vorliegenden MQC und p ein laufender Wert zwischen O und K. $B_p$ ergibt das Gewicht für die Mehrfach-Quanten-Kohärenz der Ordnung p. Ist es erwünscht, J-Kopplungen oder Spins zu refokussieren, die K - 1 oder weniger J-Kopplungen aufweisen, muß die Phase $\beta_n$ in Schritten von $\pi/N$ erhöht werden, wobei N $\geq$ K. Die Gewichte für die individuellen Schritte des $\beta$-Zyklus werden durch eine Fourier-Transformation der Werte $B_p$ erhalten, nämlich

$$W_n = \frac{1}{2}B_0 + \sum_{p=1}^{K} B_p \cos(p\beta_n) - \frac{1}{4}B_n \cos(K\beta_n)\delta K,N.$$

In der vorhergehenden Beziehung ist, wie bereits angegeben, n = 0, 1, 2, ..., N-1, N+1, ..., 2N-1.

Für den empfindlichsten Fall N = K findet man

$$W_n = \frac{N}{8} (-1)^n \left[\cos\left(\frac{n\pi}{2N}\right)\right]^{-2}.$$

Berechnete Werte für die Phasenwinkel $\beta_n$ und die zugeordneten Gewichte $W_n$ für N = K = 4 sind in der folgenden Tabelle angegeben. Die Phase $\phi_q$ muß unabhängig davon die drei Werte 0, 2/3 und 4/3 durchlaufen.

| n | 0 | $\pi/4$ | $\pi/2$ | $3\pi/4$ | $5\pi/4$ | $3\pi/2$ | $7\pi/4$ |
|---|---|---------|---------|----------|----------|----------|----------|
| $W_n$ | 0,500 | -0,5860 | 1,000 | -3,414 | -3,414 | 1,000 | 0,586 |

Das den Zeitumkehr-Impuls bildende Impulspaar 5, 6 kann demnach auch als Mehrfach-Quantenfilter betrachtet werden. Der beschriebene Phasenzyklus ist dann einer Kombination von p-Quanten-gefilterten Spektren mit den Gewichten

$\frac{1}{12}$ $(3p^2-N^2-\frac{1}{2})$ für $O \leq p \leq N$ äquivalent. Der beschrie

bene Phasenzyklus für $\beta_n$ selektiert die Kohärenz-Übertragungswege $\Delta_p$ gerade von denen nur $\Delta_p = 0$ zur Refokussierung der skalaren Kopplungen führt. Es ist daher erforderlich, den Anteil $\Delta_p = 0$ durch einen zusätzlichen Phasenzyklus des gesamten Zeitumkehr-Impulses zu selektieren. Hierzu dient der Dreischritt-Zyklus $\phi_q = 0, 2\pi/3, 4\pi/3$.

Wie bereits erwähnt, gehören die Phasen $\psi_1$ und $\psi_2$ zu üblichen NOESY-Experimenten. Ihre zyklische Variation dient der Unterdrückung axialer Linien ($\psi_1 = 0,\pi$) sowie der Ein-Quanten-Kohärenz wahrend der Mischzeit $\tau_m$ ($\psi_2 = 0,\pi$). Die Null-Quantenunterdrückung, die bei der konventionellen NOE-Spektroskopie ein bekanntes Problem bildet, ist bei NOESY mit Zeitumkehr (NOESY-TR) infolge der Refokussierung der J-Kopplungen überflüssig. Es kann selbstverständlich die Methode der zeitproportionalen Phasenerhöhung (TPPI-Methode) in der üblichen Weise auf den ersten Impuls angewendet werden, um positive und negative Frequenzen zu trennen und reine 2D-Absorptionslinien zu erhalten.

Es soll nicht unerwähnt bleiben, daß das NOESY-TR-Experiment auch gewisse Nachteile aufweist. Im Vergleich zum herkömmlichen NOESY tritt ein Empfindlichkeitsverlust um etwa den Faktor 2,5 ein, dessen genauer Wert von der Anzahl K der gekoppelten Spins abhängt. Weiterhin können unerwünschte Kreuzlinien in den Stellungen $(\omega_1, \omega_2) = (1/2\,[\Omega_k + \Omega_l]\,, \Omega_m)$ in Systemen gekoppelter Spins auftreten. Weiterhin kann der Spin $I_m$ entweder zu dem gleichen Spinsystem wie $I_k$ und $I_l$ gehören oder eine Kreuzrelaxation bezüglich $I_k$ oder $I_l$ aufweisen. Diese Linien sind jedoch leicht von den gewünschten, $\omega_1$-entkoppelten Linien zu unterscheiden, weil sie bezüglich $\omega_1$ eine gegenphasige Multipletstruktur haben. Wenn erforderlich, können die unerwünschten Linien auch in einer Weise unterdrückt werden, welche der Unterdrückung der Null-Quanten-Kohärenz bei NOESY ähnlich ist.

Die Fig. 2 bis 4 veranschaulichen in deutlicher Weise die Wirkung des erfindungsgemäßen Verfahrens bei der Aufnahme eines 2D-NOE-Spektrogrammes von Deca-peptid-LHRH oder p-Glu-His-Trp-Ser-Tyr-Gly[6]-Leu-Arg-Pro-Gly[10]-$NH_2$. Das herkömmliche NOESY-Diagramm nach Fig. 2 zeigt in den beiden eingerahmten Bereichen 11, 12 starke Überlappungen der Kreuzlinien, welche eine Zuordnung dieser Linien hindern und eine quantitative Auswertung des NOE-Spektrogrammes unmöglich machen. In den Fig. 3a und 4a sind die Bereiche 11 und 12 in vergrößertem Maßstab nochmals wiedergegeben. Die durch die Anwendung des erfindungsgemäßen Verfahrens erzielte Entkopplung in der $\omega_1$-Richtung ergibt die in den Fig. 3b und 4b wiedergegebenen 2D-Spektrogramme 13 bzw. 14. Ein Vergleich der Diagramme 11 und 13 bzw. 12 und 14 zeigt deutlich die Elimination der Linienaufspaltung in der $\omega_1$-Richtung, die nunmehr eine klare Identifikation der einzelnen Linien und damit eine einwandfreie Interpretation des Spektrogrammes ermöglicht. Die dargestellten Spektrogramme zeigen den Ausschnitt des NH-C$\alpha$H-Bereiches eines 300 MHz NOE-Spektrums. Die Aufnahme erfolgte mit 700 $t_1$-Abtastungen für eine mit Nullen aufgefüllte 2Kx2K Datenmatrix.

Die große Bedeutung des erfindungsgemäßen Verfahrens ergibt sich u.a. daraus, daß die quantitative Auswertung eines NOESY-Spektrums, d.h. die Messung der Signalamplituden der Kreuzlinien, eine direkte Information über atomare Abstände liefert. Diese Information ist von immenser Bedeutung für die Aufklärung der tertiären Strukturen von biologischen Makromolekülen. Eine solche quantitative Auswertung ist jedoch nicht möglich, wenn die Kreuzlinien im herkömmlichen NOESY-Spektrum überlappen. Das erfindungsgemäße NOESY-TR Verfahren stellt die bisher einzige Methode dar, wodurch die erwünschte Information auch bei sonst überlappenden Kreuzlinien gewonnen werden kann.

Wie bereits erwähnt, ist das erfindungsgemäße Verfahren nicht nur dazu geeignet, die Entwicklung bei einer J-Kopplung in Verbindung mit der 2D-NOE-Spektroskopie rückgängig zu machen, sondern sie ist auch für andere Zwecke einsetzbar. Tatsächlich kann der Zeitumkehr-Impuls mit den zugeordneten Phasenverschiebungen, kurz gesagt das TR-Element, in eine Vielzahl unterschiedlicher Impulsfolgen eingefügt werden, bei denen eine homo- oder heteronukleare Entkopplung erwünscht ist. Die Fig. 5 bis 10 geben Impulsfolgen wieder, wie sie bei anderen Experimenten Anwendung finden können.

Fig. 5 veranschaulicht allgemein eine Impulsfolge zur Beobachtung (homonuklearer) Austauschvorgänge, bei der zur Beobachtung der Austauschvorgänge einem $90°$-Anregungsimpuls 21 eine Entwicklungszeit $t_1$ folgt, bevor das Interferogramm 22 nach Einstrahlen eines Impulspaares 24, das einen bekannten Zwei-Quanten-Filter mit einem unabhängigen Phasenzyklus bildet, aufgenommen wird. Nach Ablauf der halben Entwicklungszeit $t_1/2$ wird das TR-Element 23 eingeführt, das wiederum in der beschriebenen Weise aus zwei $90°$-Anteilen mit den Phasenverschiebungen $\beta_n + \phi_q$ bzw. $\pi + \phi_q$ besteht. Entsprechend hat der dem TR-Element 23 vorausgehende $90°$-Impuls 21 eine Phasenverschiebung $\beta_n$. Dieses Experiment liefert ein homonuklear J-korreliertes 2D-Spektrum ohne die sonst vorhandenen, informationslosen und störenden Diagonalsignale (unkorrelierte Signale bei Frequenzen $\omega_1 = \omega_2$).

Bei der J-korrelierten 2D-Spektroskopie (COSY) wird am Ende der Entwicklungszeit $t_1$, die wiederum einem $90°$-Anregungsimpuls 31 folgt, die Mischzeit $\tau_m$ nicht durch einen weiteren $90°$-Impuls abgeschlossen, sondern es folgt nach der halben Mischzeit $\tau_m/2$ ein $180°$-Impuls 32, an den sich nach Ablauf der Mischzeit $\tau_m$ ein weiterer $90°$-Impuls 33 anschließt, auf den dann die Aufnahme des Interferogrammes 34 erfolgt. Auch hier wird wieder, wie in Fig. 6 dargestellt, erfindungsgemäß ein TR-Element 35 nach Ablauf der halben Entwicklungszeit $t_1/2$ eingefügt. Ebenso wird dem dem TR-Element 35 vorausgehenden $90°$-Impuls 31 wiederum die Phasenverschiebung $\beta_n$ erteilt. Entsprechendes gilt auch für das total korrelierte 2D-Spektrogramm (TOCSY) nach Fig. 7, bei dem lediglich während der Entwicklungszeit $\tau_m$ ein Sättigungsimpuls 36 eingestrahlt wird.

Fig. 8 zeigt das Diagramm der zur Aufnahme eines Mehrquanten-Spektrogrammes dienenden Impulsfolge. Auch hier wird wieder die Entwicklungszeit $t_1$ durch einen ersten $90°$-Impuls 41 eingeleitet und durch einen zweiten $90°$-Impuls 42 abgeschlossen. Zum Unterschied zu den vorher besprochenen Impulsfolgen sind jedoch dem die Entwicklungszeit $t_1$ einleitenden $90°$-Impuls 41 ein weiterer $90°$-Impuls 43 und ein $180°$-Impuls 44 vorgeschaltet. Die Aufnahme des Interferogrammes 45 folgt im Anschluß an den letzten $90°$-Impuls 42. Auch wird wieder erfindungsgemäß das TR-Element 46 nach der halben Entwicklungszeit $t_1/2$ in die Impulsfolge eingefügt. In diesem Falle muß nicht nur dem die Entwicklungszeit einleitenden $90°$-Impuls 41 eine Phasenverschiebung um $\beta_n$ erteilt werden, sondern auch den anderen, dem TR-Element vorhergehenden Impulsen 43 und 44.

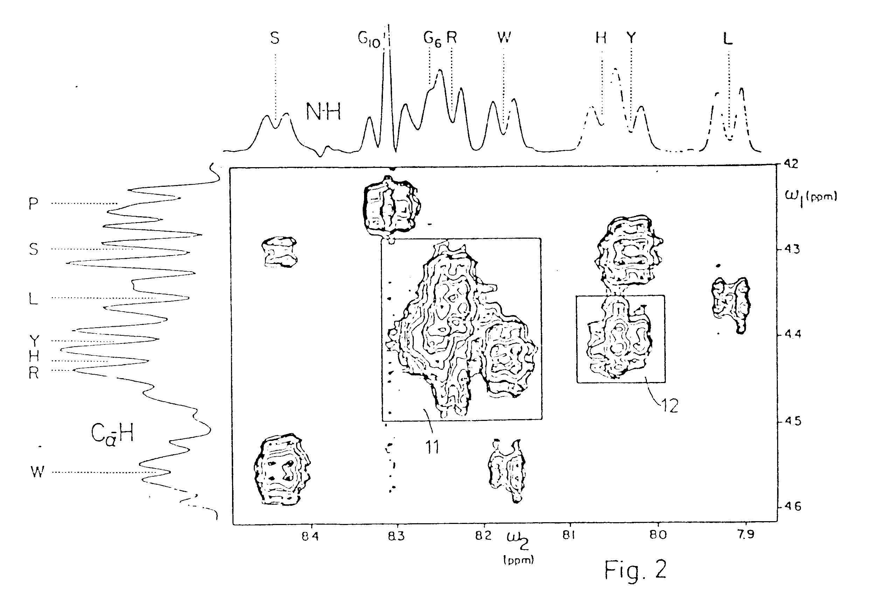

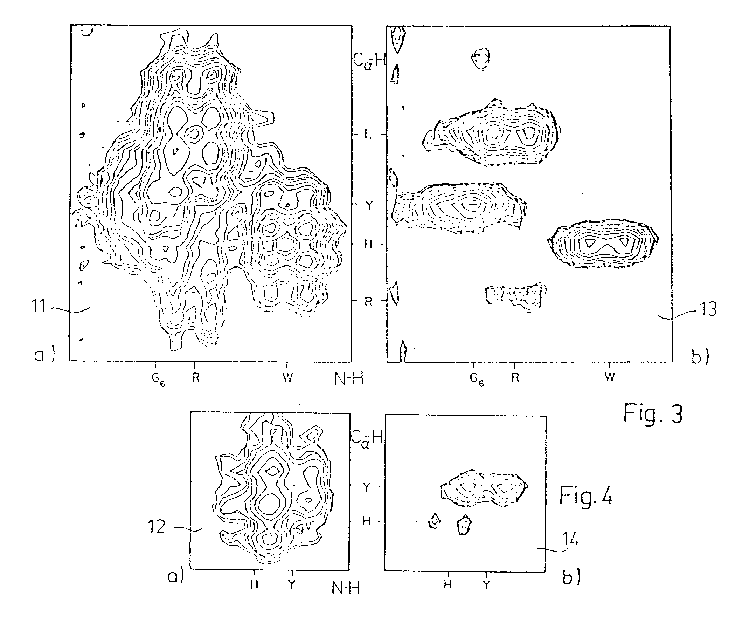

Endlich zeigen die Fig. 9 und 10 Impulsfolgen, wie sie bei der Untersuchung heteronuklearer Kopplungen und bei der indirekten Beobachtung der magnetischen Resonanz Anwendung finden. Bei der in Fig. 9 dargestellten Impulsfolge werden die H-Spins der zu untersuchenden Probe durch zwei $90°$-Impulse 51, 52 angeregt, die eine Entwicklungszeit $t_1$ auslösen bzw. beenden. Zusammen mit dem zweiten $90°$-Impuls 52 wird auch ein $90°$-Impuls 53 für die mit den H-Atomen gekoppelten X-Atome des Spinsystems eingestrahlt. Bei diesen X-Atomen kann es sich beispielsweise um Kohlenstoff-13 handeln. Das nach einem Zeitintervall $\tau'$ aufgenommene Interferogramm 54 der X-Atome zeigt an, in welchem Maße die X-Atome während der Entwicklungszeit $t_1$ durch heteronukleare Kopplung von den zuvor angeregten H-Atomen angeregt worden sind. Auch hier wird wieder nach der Erfindung das TR-Element 55 zwischen die beiden die Entwicklungszeit $t_1$ definierenden $90°$-Impulse 51, 52 eingefügt und es wird die Phase des ersten $90°$-Impulses 51 in der beschriebenen Weise abgeändert. Das Zeitintervall $\tau'$ mit $180°$-Impulsen 56, 57 in seiner Mitte dient wie üblich zur Refokussierung der Antiphasen-Signale vor dem Einschalten des Entkopplers 58.

Bei der in Fig. 10 dargestellten indirekten Spektroskopie werden die beiden Atomarten H und X im zeitlichen Abstand einer Mischzeit $\tau_m$ durch je einen $90°$-Impuls 61 bzw. 62 angeregt. Dem zeitlich späteren $90°$-Impuls, der zur Anregung der X-Atome diente, folgt ein weiterer $90°$-Impuls 63 nach der Entwicklungszeit $t_1$, wogegen die zuerst angeregte Atomart H mit einem $180°$-Impuls 64 bestrahlt wird, welcher dem ersten $90°$-Impuls nach einer Zeit $\tau_m + t_1/2$ folgt. Normalerweise würde bei der indirekten Spektroskopie die Beobachtung der ersten Atomart H im Zeitpunkt $t_1/2 + \tau_m$ nach dem $180°$-Impuls 64 folgen. Bei Anwendung des erfindungsgemäßen Verfahrens wird jedoch zur Zeit $t_1/2$ nach dem $180°$-Impuls 64 das TR-Element 65 eingefügt, das demnach zeitlich mit dem das Zeitintervall $t_1$ beendenden $90°$-Impuls 63 zusammenfällt, der auf die andere Atomart C eingestrahlt wird. Diesem TR-Element 65 folgt im zeitlichen Abstand $\tau_m + t_1/2$ ein weiterer $180°$-Impuls 66. Die Aufnahme des Interferogrammes 67 erfolgt für die erste Atomart H zur Zeit $t_1/2$ nach dem Einstrahlen des letzten 180°-Impulses 66. Betrachtet man hier die Summe der Zeiten

$$\tau_m + t_1/2 + t_1/2 + \tau_m + t_1/2 + t_1/2 = 2(t_1 + \tau_m)$$

als Gesamtentwicklungszeit von dem ersten 90°-Anregungsimpuls 61 bis zur Aufnahme des Interferogrammes 67, so ist ersichtlich, daß das TR-Element 65 wieder in die Mitte der Gesamtentwicklungszeit fällt, da sein zeitlicher Abstand von dem 90°-Anregungsimpuls 61 den Betrag $\tau_m + t_1$ hat. Auch hier versteht es sich, daß die beiden dem TR-Element 65 vorausgehenden 90°- und 180°-Impulse 61 bzw. 64 eine um den Phasenwinkel $\beta_n$ verschobene Phase der HF-Schwingung aufweisen.

Die vorstehenden Beispiele zeigen, daß das Prinzip der Erfindung bei vielen bekannten Impulsgruppen Anwendung finden kann, mit denen Spinsysteme zum Zwecke der Aufzeichnung von Spektrogrammen und insbesondere von 2D-Spektrogrammen anregbar sind. Dabei kann das TR-Element insbesondere eingefügt werden, um eine $\omega_1$-Entkopplung bei allen homo- oder heteronuklearen 2D-Experimenten zu erzielen, bei denen die Komponenten, die in bezug auf die homonuklearen Kopplungen in Phase sind, am Ende der Entwicklungszeit ausgewählt werden.

Das erfindungsgemäße Verfahren läßt sich mit allen Kernresonanzspektrometern durchführen, die einen Generator zur Erzeugung von aufeinanderfolgenden HF-Impulsen mit einstellbaren zeitlichen Abständen sowie mit einer einstellbaren Phasenlage der HF-Schwingung gegenüber einer kohärenten Bezugsschwingung aufweisen, d.h. mit allen modernen Puls Fourier Transform Spektrometern.

**Patentansprüche**

1.  Verfahren zur Aufnahme der Kernresonanzspektren von molekularen Spinsystemen, zwischen denen eine Wechselwirkung stattfindet, bei dem die Spinsysteme durch einen 90°-Impuls angeregt werden und die Beobachtung der Resonanzsignale der angeregten Spinsysteme erst nach Ablauf einer auf den 90°-Impuls folgenden Entwicklungszeit $t_1$ stattfindet, dadurch gekennzeichnet, daß das Spinsystem nach Ablauf der halben Entwicklungszeit ($t_1/2$) mit einem Zeitumkehr-Impuls (5, 6) bestrahlt wird, der eine Drehung der Spinmomente um einen Flipwinkel $\beta_n$ bewirkt und dessen HF-Schwingung gegenüber einer Referenzphasenlage eine Phasenverschiebung $\psi_q$ aufweist, wogegen die HF-Schwingung des dem Zeitumkehr-Impuls (5, 6) vorausgehenden 90°-Impulses (1) und ggf. weiterer, vor dem Zeitumkehr-Impuls (5, 6) verwendeter HF-Impulse gegenüber der Referenzphasenlage eine Phasenverschiebung um einen Winkel $\psi + \beta_n$ aufweist, in dem $\psi$ entweder o oder $\pi$ bedeutet und $\beta_n$ mit dem Flipwinkel des Zeitumkehr-Impulses (5,6) übereinstimmt und durch die maximale Anzahl N der im Spinsystem miteinander gekoppelten Spins gemäß der Gleichung

    $$\beta_n = n\frac{\pi}{N} \quad \text{mit } n = 0,1,2, ..., N-1, N+1, ...2N-1$$

    bestimmt ist, wogegen $\phi_q$ unabhängig von $\beta_n$ nacheinander einen der Werte

    $$\phi_q = q\frac{2\pi}{3} \quad \text{mit } q = 0, 1, 2$$

    annimmt und daß die mit dem Gewichtungsfaktor

    $$W_n = \frac{1}{2}B_0 + \sum_{p=1}^{K} B_p \cos(p\beta_n) - \frac{1}{4}B_K \cos(K\beta_n)\delta_{K,N}$$

    multiplizierten Signale, die aufgrund von 3(2N-1) Anregungen erhalten werden, zu einem resultierenden Signal addiert werden, welcher Gewichtsfaktor die Fourier-Transformierte der Faktoren

    $$B_p = \frac{(-1)^p}{12}(3p^2 - K^2 - \frac{1}{2})$$

ist, in denen K die höchste Anzahl der tatsächlich im Spinsystem vorkommenden Kopplungen angibt und p eine sich zwischen O und K fortlaufend ändernde, ganze Zahl ist, weshalb

$$B_O = \frac{-(2K^2 + 1)}{24} \quad \text{und} \quad B_K = (-1)\frac{K(4K^2 - 1)}{24},$$

während $\delta_{K,N}$ den Wert 1 hat, wenn N = K, und sonst null ist.

2. Verfahren nach Anspruch 1, dadurch gekennzeichnet, daß der Zeitumkehr-Impuls (5, 6) einen ersten Abschnitt (5) in Form eines 90°-Impulses mit der Phase $\beta_n + \phi_q$ und einen dem ersten Abschnitt ggf. mit einem gegenüber der Entwicklungszeit kurzen, zeitlichen Abstand $\tau$ folgenden zweiten Abschnitt (6) in Form eines 90°-Impulses mit der Phase $\pi + \phi_q$ aufweist.

3. Verfahren nach Anspruch 1 oder 2, gekennzeichnet durch die Verwendung von zur Aufnahme von zweidimensionalen Kernresonanzspektren geeigneten Impulsfolgen mit eingefügtem Zeitumkehr-Impuls (5, 6) und um den Winkel $\beta_n$ verschobener Phase der HF-Schwingung der dem Zeitumkehr-Impuls (5, 6) vorausgehenden Anregungsimpulse (1).

4. Verfahren nach Anspruch 3, gekennzeichnet durch die Verwendung der Impulsfolge

$$90°(\beta_n + \psi_1) - \tfrac{1}{2} t_1 - 90°(\beta_n + \phi_q) - \tau - 90°(\pi + \phi_q) - \tfrac{1}{2} t_1 - 90°(0) - \tau_m - 90°(\psi_2) - \text{acq.} (\psi_1 + \psi_2)$$

mit $\psi_1$, $\psi_2$ = 0,$\pi$ in einem von $\beta$ und $\phi$ unabhängigen zyklischen Wechsel und einer variablen Mischzeit $\tau_m$ für NOESY-Experimente.

5. Verfahren nach Anspruch 3 zur Untersuchung von Spinsystemen mit heteronuklearer Kopplung, bei dem durch eine erste Impulsfolge eine erste Kernart (H) unmittelbar angeregt und dann durch eine zweite Impulsfolge die durch Kopplung erfolgte Anregung der zweiten Kernart (X) abgefragt wird, dadurch gekennzeichnet, daß der Zeitumkehr-Impuls (55) in die erste Impulsfolge eingefügt wird.

6. Verfahren nach Anspruch 3 zur indirekten Untersuchung von Spinsystemen mit heteronuklearer Kopplung, bei dem mittels einer ersten Impulsfolge eine erste Kernart (H) und mittels einer zweiten Impulsfolge eine zweite Kernart (X) in der Weise angeregt wird, daß ein einem ersten 90°-Impuls der ersten Impulsfolge folgender erster 180°-Impuls in die Mitte zwischen zwei 90°-Impulse der zweiten Impulsfolge fällt, dadurch gekennzeichnet, daß der Zeitumkehrimpuls (65) in die erste Impulsfolge an einer Stelle eingefügt ist, die zeitlich mit dem zweiten 90°-Impuls (63) der zweiten Impulsfolge zusammenfällt, daß dem Zeitumkehr-Impuls (65) ein weiterer 180°-Impuls (66) in einem zeitlichen Abstand folgt, der dem Abstand des ersten 180°-Impulses (64) von dem ersten 90°-Impuls (61) gleich ist, und daß die Abtastung des von der ersten Kernart (H) gelieferten Resonanzsignales in einem zeitlichen Abstand vom weiteren 180°-Impuls (66) beginnt, der gleich dem zeitlichen Abstand des Zeitumkehr-Impulses (65) von dem ersten 180°-Impuls (64) ist, so daß der Zeitumkehr-Impuls (65) in die Mitte zwischen den ersten 90°-Impuls (61) und den Beginn der Signalabtastung (67) fällt.

## Claims

1. Method for recording the nuclear magnetic resonance spectra of molecular spin systems between which there is an interactive effect in which said spin systems are excited by means of 90° pulse and the resonance signals of the excited spin systems are not observed until the end of an evolution period $t_1$ that follows the 90° pulse, characterized in that said spin system is irradiated with a time reversal pulse (5,6) after one half of the evolution period ($t_1/2$), with said time reversal pulse (5,6) causing the spin moments to rotate by a flip angle $\beta_n$ and the RF oscillation of said time-reversal pulse having a phase shift of $\phi_q$ relative to a reference phase, while the RF oscillation of pulses that precede said time reversal pulse (5,6) have a phase shift of $\psi + \beta_n$ relative to said reference phase, in which phase shift $\psi$ represents either 0 or $\pi$ and $\beta_n$ coincides with said flip angle of said time reversal pulse and is determined by the maximum number N of coupled spins in said spin system, in accordance with the equation

$$\beta_n = n\frac{\pi}{N}$$

wherein n = 0, 1, 2, ..., N-1, N+1, ..., 2N-1 while $\phi_q$ independently of $\beta_n$ assumes one of the values

$$\phi_q = q\frac{2\pi}{3}$$

wherein q = 0, 1, 2, and in that signals which are received on the basis of 3(2N-1) excitations, are multiplied by a weighting factor of

$$W_n = \tfrac{1}{2}B_0 + \sum_{p=1}^{K} B_p \cos(p\beta_n) - \tfrac{1}{4}B_K \cos(K\beta_n)\delta_{K,N}$$

and then added together to form a resulting signal, which weighting factor is the Fourier transformation of the factors

$$B_p = \frac{(-1)^p}{12}(3p^2 - K^2 - \tfrac{1}{2})$$

in which K represents the highest number of couplings that are actually present in said spin system and p represents a continuously changing integer between O and K, so that

$$B_0 = \frac{-(2K^2 + 1)}{24} \quad \text{and} \quad B_K = (-1)\frac{K(4K^2 - 1)}{24}$$

while $\delta_{K,N}$ has a value of 1 if N = K and otherwise is zero.

2. Method according to claim 1, characterized in that said time reversal pulse (5, 6) has a first portion (5) in the form of a 90° pulse having a phase of $\beta_n + \phi_q$ and a second portion (6) which, with a time delay short compared with the evolution period if any, follows said first portion in the form of a 90° pulse having a phase of $\pi + \phi_q$.

3. Method according to claim 1 or 2, characterized in that pulse sequences are employed which are suitable for recording two-dimensional nuclear magnetic resonance spectra and have an inserted time reversal pulse (5, 6) and in which the phase of the RF oscillation of the excitation pulses (1) that precede the time reversal pulse (5, 6) is shifted by angle $\beta_n$.

4. Method according to claim 3, characterized in that the pulse sequence is

$$90°(\beta_n + \psi_1) - \tfrac{1}{2}t_1 - 90°(\beta_n + \phi_q) - \tau - 90°(\pi + \phi_q) - \tfrac{1}{2}t_1 - 90°(0) - \tau_m - 90°(\psi_2) - \text{acq.}(\psi_1 + \psi_2)$$

wherein $\psi_1$ and $\psi_2$ are alternatively 0 and $\pi$ in a cycle that is independent of $\beta$ and $\phi$ and $\tau_m$ is the variable mixing time of NOESY experiments.

5. Method according to claim 3 for investigation of spin systems with heteronuclear coupling, in which a first kind of nuclei (H) is directly excited by a first pulse sequence and then the excitation by coupling of a second kind of nuclei (X) is examined by means of a second pulse sequence, characterized in that the time reversal pulse (55) is inserted into said first pulse sequence.

**6.** Method according to claim 3 for indirect investigation of spin systems with heteronuclear coupling in which a first kind of nuclei (H) is excited by means of a first pulse sequence and a second kind of nuclei (X) is excited by means of a second pulse sequence in such a manner that a first 180° pulse following a first 90° pulse of said first pulse sequence is centred between two 90° pulses of said second pulse sequence, characterized in that said time reversal pulse (65) is inserted in said first pulse sequence at a location that is in time coincidence with said second 90° pulse (63) of said second pulse sequence, said time reversal pulse (65) is followed by a further 180° pulse (66) after a time interval that is identical to the time interval between said first 90° pulse (61) and said first 180° pulse (64), and scanning of the resonance signal provided by said first kind of nuclei (H) starts after a time interval from said further 180° pulse (66) that is identical to the time interval between said first 180° pulse (64) and said time reversal pulse (65), so that said time reversal pulse (65) is centred between said first 90° pulse (61) and start of said signal scanning (67).

**Revendications**

**1.** Procédé de prise de spectres de résonance nucléaire de systèmes de spins moléculaires, entre lesquels a lieu une interaction, procédé dans lequel les systèmes de spins sont excités par une impulsion de 90° et l'observation des signaux de résonance des systèmes de spins excités n'a lieu qu'au bout d'un temps de développement $t_1$ suivant l'impulsion de 90°, caractérisé en ce que le système de spins est, au bout de la moitié du temps de développement ($t_1/2$), exposé à une impulsion d'inversion de temps (5, 6) qui produit une rotation des moments de spin d'un angle de baculement $\beta_n$ et dont l'oscillation HF présente un déphasage $\phi_q$ par rapport à une position de phase de référence, tandis que l'oscillation HF de l'impulsion de 90° (1) précédant l'impulsion d'inversion de temps (5, 6) et éventuellement d'autres impulsions HF utilisées avant l'impulsion d'inversion de temps (5, 6) présente, par rapport à la position de phase de référence, un déphasage d'un angle $\psi + \beta_n$, où $\psi$ représente soit o soit $\pi$ et $\beta_n$ coïncide avec l'angle de basculement de l'impulsion d'inversion de temps (5, 6) et est déterminé, par le nombre maximal N des spins couplés l'un à l'autre dans le système de spins, conformément à l'équation

$$\beta_n = n\frac{\pi}{N} \text{ avec } n = 0,1,2, ..., N\text{-}1, N+1, ...2N\text{-}1$$

tandis que $\phi_q$ adopte, indépendamment de $\beta_n$, successivement une des valeurs

$$\phi_q = q\frac{2\pi}{3} \text{ avec } q = 0, 1, 2$$

et en ce que les signaux multipliés par le facteur de pondération

$$W_n = \frac{1}{2}B_0 + \sum_{p=1}^{K} B_p \cos(p\beta_n) - \frac{1}{4}B_K \cos(K\beta_n)\delta_{K,N}$$

qui sont obtenus en raison de 3(2N-1) excitations, sont additionnés en un signal résultant, le facteur de pondération étant la transformée de Fourier des facteurs

$$B_p = \frac{(-1)^p}{12}(3p^2 - K^2 - \frac{1}{2})$$

où K indique le nombre maximal des couplages apparaissant effectivement dans le système de spins et p est un nombre entier qui se modifie progressivement entre O et K, d'où

$$B_O = \frac{-(2K^2 + 1)}{24} \quad \text{et} \quad B_K = (-1)\frac{K(4K^2-1)}{24},$$

tandis que $\delta_{K,N}$ a la valeur de 1 , lorsque N = K, et est par ailleurs égal à zéro.

2. Procédé suivant la revendication 1, caractérisé en ce que l'impulsion d'inversion de temps (5, 6) présente une première section (5) sous la forme d'un impulsion de 90° avec la phase $\beta_n + \phi_q$ et une deuxième section (6), sous la forme d'une impulsion de 90° avec la phase $\pi + \phi_q$, qui suit la première section éventuellement avec un court écart de temps $\tau$ par rapport au temps de développement.

3. Procédé suivant l'une des revendications 1 et 2, caractérisé par l'utilisation de suites d'impulsions appropriées pour la prise de spectres de résonance nucléaire bidimensionnels et présentant une impulsion d'inversion de temps (5, 6) insérée et une phase, décalée de l'angle $\beta_n$, de l'oscillation HF des impulsions d'excitation (1) qui précèdent l'impulsion d'inversion de temps (5, 6).

4. Procédé suivant la revendication 3, caractérisé par l'utilisation des suites d'impulsions

$90°(\beta n + \psi_1) - \frac{1}{2} t_1 - 90°(\beta_n + \phi_q) - \tau - 90°(\pi + \psi_q) - \frac{1}{2} t_1 - 90°(0) - \tau_m - 90°(\psi_2) - \text{acq.} (\psi_1 + \psi_2)$

avec $\psi_1, \psi_2 = 0, \pi$ dans un changement cyclique indépendant de $\beta$ et de $\phi$ et un temps de mélange variable $\tau_m$ pour des expériences NOESY.

5. Procédé suivant la revendication 3, pour l'examen de système de spins à couplage hétéronucléaire, dans lequel un premier type de noyau (H) est directement excité par une première suite d'impulsions et l'excitation du deuxième type de noyau (X), qui est obtenue par couplage, est lue grâce à une deuxième suite d'impulsions, caractérisé en ce que l'impulsion d'inversion de temps (55) est insérée dans la première suite d'impulsions.

6. Procédé suivant la revendication 3, pour l'examen indirect de systèmes de spins à couplage hétéronucléaire, dans lequel un premier type de noyau (H) est excité au moyen d'une première suite d'impulsions et un deuxième type de noyau (X) au moyen d'une deuxième suite d'impulsions de manière qu'une première impulsion de 180° suivant une première impulsion de 90° de la première suite d'impulsions tombe au milieu entre deux impulsions de 90° de la deuxième suite d'impulsions, caractérisé en ce que l'impulsion d'inversion de temps (65) est insérée dans la première suite d'impulsions à un endroit qui, dans le temps, coïncide avec la deuxième impulsion de 90° (63) de la deuxième suite d'impulsions, qu'à l'impulsion d'inversion de temps (65) fait suite une autre impulsion de 180° (66) à un écart dans le temps qui est égal à l'écart entre la première impulsion de 180° (64) et la première impulsion de 90° (61) et que l'exploration du signal de résonance fourni par le premier type de noyau (H) commence à un intervalle de temps de l'autre impulsion de 180° (66) qui est égal à l'intervalle de temps entre l'impulsion d'inversion de temps (65) et la première impulsion de 180° (64), de façon que l'impulsion d'inversion de temps (65) tombe au milieu entre la première impulsion de 90° (61) et le commencement de l'exploration de signal (67).

Fig. 1

Fig. 5

Fig. 6

Fig. 7

Fig. 8

Fig. 9

Fig. 10

Fig. 2

EP 0 224 854 B1

Fig. 3

Fig. 4